# EUROPÄISCHE PATENTSCHRIFT

(11) **EP 1 624 565 B1**
(45) Veröffentlichungstag und Bekanntmachung des Hinweises auf die Patenterteilung: **27.02.2008**
(21) Anmeldenummer: 05106105.9
(22) Anmeldetag: 05.07.2005
(51) Int. Cl.: H03G 3/30

(54) **Empfangsschaltung zum Empfangen von OFDM-Signalen und Verfahren hierzu**
OFDM receiver and receiving method
Récepteur et procédé de réception d'un signal OFDM

(30) Priorität: 05.08.2004 DE 102004037916
(43) Veröffentlichungstag der Anmeldung: 08.02.2006
(73) Patentinhaber: Robert Bosch GmbH, 70442 Stuttgart (DE)
(72) Erfinder: Hofmann, Frank, 31139 Hildesheim (DE); Spreitz, Gerald, 30880 Laatzen (DE); Jakoblew, Sascha, 31141 Hildesheim (DE); Grun, Daniel, 31135 Hildesheim (DE)

(56) Entgegenhaltungen:
- EP-A- 1 432 156
- WO-A-03/041312
- US-A- 4 667 334
- US-A- 4 776 040
- US-B1- 6 400 933

## Beschreibung

Die Erfindung betrifft eine Empfangsschaltung, insbesondere zum Empfangen von OFDM-Signalen, insbesondere von OFDM-Funksignalen, wie sie beispielsweise zur Übertragung für den digitalen Runkfunk (DAB digital audio broadcasting) verwendet werden. Die Erfindung betrifft weiterhin ein Verfahren insbesondere zum Empfangen von OFDM-Signalen.

Moderne Empfänger von digitalen Funksignalen, z.B. für den digitalen Radioempfang, empfangen die digitalen Signale als OFDM-Empfangssignale. Die OFDM-Empfangssignale werden in einem vorgegebenen Frequenzbereich in einem bestimmten Format übertragen. Das bestimmte Format umfasst Rahmen, in denen mehrere Symbole gruppiert sind. Ein solcher Rahmen umfasst Symbole für die zeitliche Synchronisation der Rahmen, ein oder mehrere Symbole zum Angeben des Inhalts eines Rahmens des OFDM-Empfangssignals in dem bestimmten Frequenzbereich, sowie Nutzsymbole, die die Nutzdaten tragen. Ein OFDM-Empfangssignal in einem Frequenzbereich wird im folgenden als Kontext bezeichnet.

Es kann erforderlich sein, dass ein OFDM-Empfänger zwischen zwei Kontexten, d.h. zwischen zwei Frequenzbereichen, die OFDM-Empfangssignale tragen, wechseln muss. Dies ist beispielsweise bei dem sogenannten "Snooping" (Schnüffeln) der Fall, wobei dem während des Empfangs eines Kontexts ein weiterer Kontext überprüft werden soll, insbesondere dessen Signalstärke und dessen Inhalte. Dazu wird zu geeigneten Zeitpunkten von einem Kontext auf einen weiteren Kontext umgeschaltet.

Empfänger für OFDM-Empfangssignale weisen üblicherweise eine AGC- (automatic gain control) Schaltung, d.h. eine Verstärkerschaltung zum Verstärken der empfangenen Funksignale auf. Aufgabe einer solchen Verstärkerschaltung ist es, die Empfangssignale so zu verstärken, dass ein Ausgangssignal am Ausgang der Empfangsschaltung mit einer vorbestimmten Stärke zur Verfügung gestellt wird. Eine solche Verstärkerschaltung muss in der Lage sein, ein sehr schwaches Empfangssignal, als auch ein sehr starkes Empfangssignal zu empfangen und in das Ausgangssignal mit der vorbestimmten Stärke umzuwandeln. Daher muss eine solche Verstärkerschaltung einen sehr hohen Dynamikbereich aufweisen. Bisher wird eine solche Eingangsverstärkerschaltung mithilfe einer analogen einstellbaren Verstärkereinheit (AGC) realisiert, die kontinuierlich die Verstärkung an die Stärke des Empfangssignals anpasst, um das Ausgangssignal mit der vorbestimmten Stärke zu erhalten.

Bei der Verwendung einer digitalen Verstärkerschaltung wird die Verstärkung zyklisch oder zu bestimmten Zeitpunkten eingestellt, wobei keine kontinuierliche, sondern eine stufenweise Anpassung der Verstärkung erfolgt.

Bei einem Kontextwechsel kann es vorkommen, dass die Kontexte in den verschiedenen Frequenzbereichen in unterschiedlicher Stärke vorliegen. Insbesondere beim "Snooping", wo kurzfristig innerhalb eines Rahmens auf einen anderen Frequenzbereich gewechselt wird, um danach wieder zu dem Kontext auf dem ursprünglichen Frequenzbereich zurückzukehren, können unterschiedliche Signalstärken der Empfangssignale in den verschiedenen Frequenzbereichen vorliegen. Dies führt bei einer festen Verstärkungseinstellung der Verstärkungsschaltung dazu, dass das Empfangssignal in dem weiteren Frequenzbereich zu einem übersteuerten Ausgangssignal führt, wenn das Empfangssignal in dem weiteren Frequenzbereich stärker ist als das Empfangssignal in dem ursprünglichen Frequenzbereich, oder dass das Ausgangssignal zu gering verstärkt ist, wenn das Empfangssignal in dem weiteren Frequenzbereich schwächer ist, als das Empfangssignal in dem ursprünglichen Frequenzbereich. Während des kurzen Umschaltens auf den weiteren Frequenzbereich ist es der Verstärkerschaltung nicht möglich, ausgehend von einem beliebigen Verstärkungswert die vorbestimmte Sollstärke des Zwischensignals einzustellen, so dass das "Snooping" nur möglich ist, wenn das Empfangssignal in dem Frequenzbereich und das Empfangssignal in dem weiteren Frequenzbereich etwa die gleiche Signalstärke aufweist. Sind die Signalstärken voneinander verschieden, kann beim Kontextwechsel der Inhalt des Empfangssignals in dem weiteren Frequenzbereich nicht erkannt werden.

Aus der EP 1432156 A1 ist ein Verfahren und eine Vorrichtung zum Empfang von Rundfunksignalen bekannt, wobei das Programm auf unterschiedlichen Frequenzen übertragen wird und auf diesen Alternativfrequenzen überwacht wird. Bei der Umschaltung auf eine der Alternativfrequenzen wird die Verstärkung des Verstärkers unverzögert vom derzeitigen Wert auf einen Wert umgeschaltet, der zur gewählten Alternativfrequenz gehört.

Aus der WO 03/041312 A1 ist ein DAB-Empfänger bekannt, der Filter, Verstärker und Mischer aufweist, wobei die beiden hintereinander angeordneten Verstärker jeweils PIN-Detektoren zur Leistungserfassung aufweisen, und in Abhängigkeit des gemessenen Signalpegels der jeweilige Verstärker hinsichtlich seiner Verstärkungswerte geregelt wird.

Aus der US 4,776,040 ist ein Superheterodyn-Empfänger bekannt, bei dem unerwünschte Störungen in einem Nachbarband, das die Verstärkung innerhalb des Empfangsbandes verringert, vermieden wird. Hierzu werden die Ausgangspegel sowohl des Hochfrequenzverstärkers als auch des ersten Mischers erfasst, aufsummiert und das Summensignal dem Eingang der Verstärkungssteuerung des Hochfrequenzverstärkers zugeführt.

Aus der US 6,400,933 ist ein Verstärker für einen Empfänger eines Video- oder Rundfunkgeräts bekannt, der die Eingangssignale verstärken soll aber das Signal möglichst wenig verrauscht und das Signal möglichst wenig verzerrt. Hierzu wird eine Verstärkerstufe des mindestens zweistufigen Verstärkers überbrückt, wenn nicht die volle Verstärkungsleistung benötigt wird.

Aus der US 4,667,334 ist ein Radiorundfunksystem bekannt, das binäre Datenpakete an mobile Empfänger sendet. Die Anfangsteile der Pakete werden periodisch übertragen, wobei die Vorsilbe der Pakete Synchronisationsinformation beinhalten. Zur Synchronisation werden die Phase und eine Phasennachführung ermittelt. Der Übergang von der Phasensuche zur Phasennachführung (Einrasten der Phase) geschieht in dem Moment, wenn zwei hintereinander folgende Zeichen mit dem Hamming-Abstand Null erkannt werden.

Es ist daher Aufgabe der vorliegenden Erfindung, eine Empfangsschaltung zur Verfügung zu stellen, mit der ein Kontextwechsel so durchgeführt werden kann, dass der Kontext in dem weiteren Frequenzbereich sicher detektiert werden kann und somit die darin enthaltenen Informationen zuverlässig erkannt werden können.

Es ist weiterhin Aufgabe der vorliegenden Erfindung, ein Verfahren zum Empfangen von OFDM-Empfangssignalen zur Verfügung zu stellen, mit dem ein Kontextwechsel zuverlässig durchgeführt werden kann.

Diese Aufgabe wird durch die Empfangsschaltung nach Anspruch 1, sowie durch das Verfahren nach Anspruch 14 gelöst.

Weitere vorteilhafte Ausgestaltungen der Erfindung sind in den abhängigen Ansprüchen angegeben.

Gemäß einem ersten Aspekt der vorliegenden Erfindung ist eine Empfangsschaltung insbesondere zum Empfangen von OFDM-Empfangssignalen vorgesehen. Die Empfangsschaltung weist eine Eingangsschaltung auf, um abhängig von einem Frequenzwahlsignal ein erstes Empfangssignal in einem ersten Frequenzbereich oder ein zweites Empfangssignal in einem zweiten Frequenzbereich umzuwandeln, um ein Ausgangssignal mit Nutzdaten zu erhalten. Es ist weiterhin eine digital einstellbare Verstärkereinheit vorgesehen, um das Ausgangssignal mit einer vorbestimmten Signalstärke zur Verfügung zu stellen. Weiterhin ist eine Verstärkersteuereinheit mit der Verstärkereinheit verbunden, um bei einem Kontextwechsel zwischen dem ersten Empfangssignal und dem zweiten Empfangssignal hin und zurück zu wechseln, ohne dass ein aus dem Ausgangssignal generiertes Nutzsignal bezüglich des ersten Empfangssignals wahrnehmbar unterbrochen wird, und um beim Empfangen des ersten Empfangssignals die Verstärkung der Verstärkereinheit gemäß einem ersten bereitgestellten Verstärkungswert und beim Empfangen des zweiten Empfangssignals die Verstärkung der Verstärkereinheit gemäß einem zweiten bereitgestellten Verstärkungswert einzustellen. Vorzugsweise werden der erste Verstärkungswert bzw. der zweite Verstärkungswert durch eine erste Verstärkungsspeichereinheit, bzw. eine zweite Verstärkungsspeichereinheit bereitgestellt.

Die erfindungsgemäße Empfangsschaltung hat den Vorteil, dass ein Kontextwechsel auch zwischen zwei Kontexten möglich ist, deren Empfangssignale in unterschiedlicher Stärke am Eingang der Eingangschaltung anliegen. Während bisherige Empfangsschaltungen für das Empfangen von Empfangssignalen eine analog einstellbare Verstärkerschaltung (analoge AGC) vorsehen, die sich einem Kontextwechsel nicht schnell genug an die Stärke des Empfangssignals des weiteren Kontextes anpassen kann, wird erfindungsgemäß eine digital einstellbare Verstärkerschaltung vorgesehen, die bei einem Kontextwechsel jeweils zuvor bestimmte dem Kontext zugeordnete Verstärkungswerte benutzt, um das jeweilige Empfangssignal zu verstärken. Somit wird beim Empfangen eines ersten Kontextes, d.h. eines ersten Empfangssignals in einem ersten Frequenzbereich, ein erster Verstärkungswert verwendet, um das erste Empfangssignal zu verstärken. Beim Kontextwechsel wird zur Verstärkung eines zweiten Empfangssignals ein zweiter Verstärkungswert benutzt.

Die Verstärkungswerte ergeben sich aus der stufenweisen Anpassung des Verstärkungswerts der Verstärkerschaltung an die Stärke des jeweils empfangenen Empfangssignals, so dass bei jedem Kontextwechsel die Anpassung der Verstärkung von dem zuletzt eingenommenen Verstärkungswert fortgesetzt werden kann. Im Gegensatz dazu ist es nicht möglich, den Verstärkungswert einer analogen Verstärkerschaltung so abzuspeichern, dass bei oder nach einem Kontextwechsel die Anpassung der Verstärkung des jeweiligen Kontextes ausgehend mit der letzten eingestellten Verstärkung des betreffenden Kontextes fortgesetzt wird. Dadurch wird es möglich, bei einem kurzfristigen Wechsel von einem ersten Empfangssignal zu einem zweiten Empfangssignal sofort eine geeignete Verstärkung des zweiten Empfangssignals vornehmen zu können, so dass der Inhalt des zweiten Empfangssignals erkannt werden kann.

Vorzugsweise weist die Verstärkereinheit ein erstes Verstärkerelement zum Verstärken des Empfangssignals mit einem ersten Teilverstärkungswert und ein zweites Verstärkerelement zum Verstärken eines Zwischensignals mit einem zweiten Teilverstärkungswert auf, wobei ein erster Frequenzumsetzer zum Wandeln des verstärkten Empfangssignals in das Zwischensignal und ein zweiter Frequenzumsetzer zum Wandeln des Zwischensignals in das Ausgangssignal vorgesehen ist, um das Ausgangssignal mit der vorbestimmten Signalstärke zu erhalten.

Gemäß einer bevorzugten Ausführungsform der Erfindung kann die Verstärkereinheit die Verstärkung zu durch ein Aktivierungssignal vorgegebenen Zeitpunkten einstellen.

Die Verstärkersteuereinheit kann den ersten und den zweiten Teilverstärkungswert adaptiv anpassen, wobei der erste Teilverstärkungswert abhängig von der Differenz zwischen der aktuellen Signalstärke und einem vorbestimmten Signalstärkebereich des verstärkten Empfangssignals einstellt und/oder den zweiten Verstärkungswert abhängig von der Differenz zwischen der aktuellen Signalstärke des Ausgangssignals und einer vorbestimmten Signalstärke des Ausgangssignals ändert.

Um dies durchzuführen, kann die Verstärkersteuereinheit einen ersten Pegeldetektor aufweisen, um eine erste Signalstärke des Empfangssignals zu detektieren, und einen zweiten Pegeldetektor aufweisen, um eine zweite Signalstärke des Ausgangssignals zu detektieren.

Es kann vorgesehen sein, dass die Verstärkersteuereinheit mehrere erste Signalstärkenbereiche mithilfe von einem oder mehreren ersten Schwellwerten, die die Grenzen der Signalstärkenbereiche bilden, definiert, um den ersten Teilverstärkungswert abhängig davon festzulegen, in welchem der ersten Signalstärkenbereiche sich die erste Signalstärke des Empfangssignals befindet.

Vorzugsweise weist mindestens einer der ersten Schwellwerte der mehreren ersten Signalstärkenbereiche eine Hysterese auf. Weiterhin kann die Verstärkersteuereinheit so gestaltet sein, um die Differenz zwischen der zweiten Signalstärke und der vorbestimmten Signalstärke des Ausgangssignals zu ermitteln und abhängig von der Differenz eine Änderung des zweiten Teilverstärkungswertes vorzunehmen. Insbesondere kann die Änderung des Betrags des zweiten Teilverstärkungswertes umso größer eingestellt werden, je größer der Betrag der Differenz zwischen der aktuellen Signalstärke des Ausgangssignals und der vorbestimmten Signalstärke des Ausgangssignals ist.

Gemäß einer weiteren Ausführungsform kann eine Auswerteeinheit vorgesehen sein, um das Ausgangssignal zu erhalten und daraus ein Nutzsignal in einem Band, d.h. in dem Nutzsignal zugrunde liegenden Frequenzbereich, zu generieren. Die Auswerteeinheit misst eine Nutzsignalstärke des Nutzsignals, wobei der Auswerteeinheit die erste und/oder die zweite Signalstärke, sowie der erste und der zweite Teilverstärkungswert zur Verfügung gestellt wird, wobei aus der Nutzsignalstärke und dem ersten und/oder zweiten Teilverstärkungswert die Feldstärke des Empfangssignals im ersten und im zweiten Frequenzbereich bestimmbar ist, um für den Empfang der Nutzdaten das erste oder das zweite Empfangssignal abhängig von der Feldstärke des jeweiligen Empfangssignals auszuwählen.

Es kann vorgesehen sein, dass die Auswerteeinheit die Nutzsignalstärke und die zweite Signalstärke miteinander vergleicht, um die Störsignalstärke von einem zu dem ersten bzw. zweiten Frequenzbereich benachbarten Frequenzbereich zu bestimmen, wobei die Auswerteeinheit weiterhin den ersten Frequenzbereich oder den zweiten Frequenzbereich für dem Empfang des Empfangssignals abhängig von der Störsignalstärke auswählt. Abhängig von dem ausgewählten ersten oder zweiten Frequenzbereich kann die Auswerteeinheit einen Kontextwechsel durchführen.

Gemäß einem weiteren Aspekt der vorliegenden Erfindung ist ein Verfahren zum Empfangen von OFDM-Empfangssignalen vorgesehen. Abhängig von einem Frequenzwahlsignal wird ein erstes Empfangssignal in einem ersten Frequenzbereich oder ein zweites Empfangssignal in einem zweiten Frequenzbereich umgewandelt, um ein Ausgangssignal mit Nutzdaten zu erhalten. Das entsprechende Empfangssignal wird gemäß einer Verstärkung so verstärkt, um ein Ausgangssignal mit einer vorbestimmten Signalstärke zu erhalten. Bei einem Kontextwechsel wird zwischen dem Empfangen des ersten Empfangssignals und dem Empfangen des zweiten Empfangssignals gewechselt, ohne das Ausgangssignal bezüglich des ersten Empfangssignals zu unterbrechen. Beim Empfangen des ersten Empfangssignals wird das erste Empfangssignal gemäß einem ersten Verstärkungswert und beim Empfangen des zweiten Empfangssignals das zweite Empfangssignal gemäß einem zweiten Verstärkungswert verstärkt. Die Vorteile des erfindungsgemäßen Verfahrens entsprechen im Wesentlichen den Vorteilen der erfindungsgemäßen Empfangsschaltung.

Gemäß einer Ausführungsform des erfindungsgemäßen Verfahrens wird das Empfangssignal mit einem ersten Teilverstärkungswert und ein aus dem Empfangssignal erhaltenes Zwischensignal mit einem zweiten Teilverstärkungswert verstärkt, wobei das verstärkte Empfangssignal durch Mischen in das Zwischensignal gewandelt und das Zwischensignal durch ein weiteres Mischen in das Ausgangssignal gewandelt wird, um das Ausgangssignal mit der vorbestimmten Signalstärke zu erhalten. Der erste Teilverstärkungswert wird abhängig von der Differenz zwischen der aktuellen Signalstärke und einem vorbestimmten Signalstärkebereich des Empfangssignals eingestellt, und/oder der zweite Verstärkungswert wird abhängig von der Differenz zwischen der aktuellen Signalstärke des Ausgangssignals und einer vorbestimmten Signalstärke des Ausgangssignals geändert.

Eine erste Signalstärke des Empfangssignals und eine zweite Signalstärke des Ausgangssignals können detektiert werden. Für das erste und zweite Empfangssignal werden aus den jeweiligen Ausgangssignalen ein Nutzsignal im Basisband generiert, wobei eine Nutzsignalstärke des jeweiligen Nutzsignals gemessen wird. Aus den Nutzsignalstärken und den jeweiligen ersten und/oder zweiten Signalverstärkungswerten werden die Signalstärken des ersten und zweiten Empfangssignals im ersten Frequenzbereich und im zweiten Frequenzbereich bestimmt, um für den Empfang der Nutzdaten den ersten oder den zweiten Frequenzbereich abhängig von der ersten Signalstärke des ersten bzw. zweiten Empfangssignals auszuwählen.

Gemäß einer Ausführungsform des erfindungsgemäßen Verfahrens werden die Nutzsignalstärken des ersten und des zweiten Empfangssignals und die jeweilige zweite Signalstärke miteinander verglichen, um die Störsignalstärken von einem zu dem jeweiligen Frequenzbereich des ersten bzw. zweiten Empfangssignals benachbarten Frequenzbereichs zu bestimmen, wobei weiterhin der erste Frequenzbereich oder zweite Frequenzbereich abhängig von der Störsignalstärke ausgewählt wird.

Eine bevorzugte Ausführungsform der Erfindung wird nachfolgend anhand der beigefügten Zeichnungen näher erläutert.

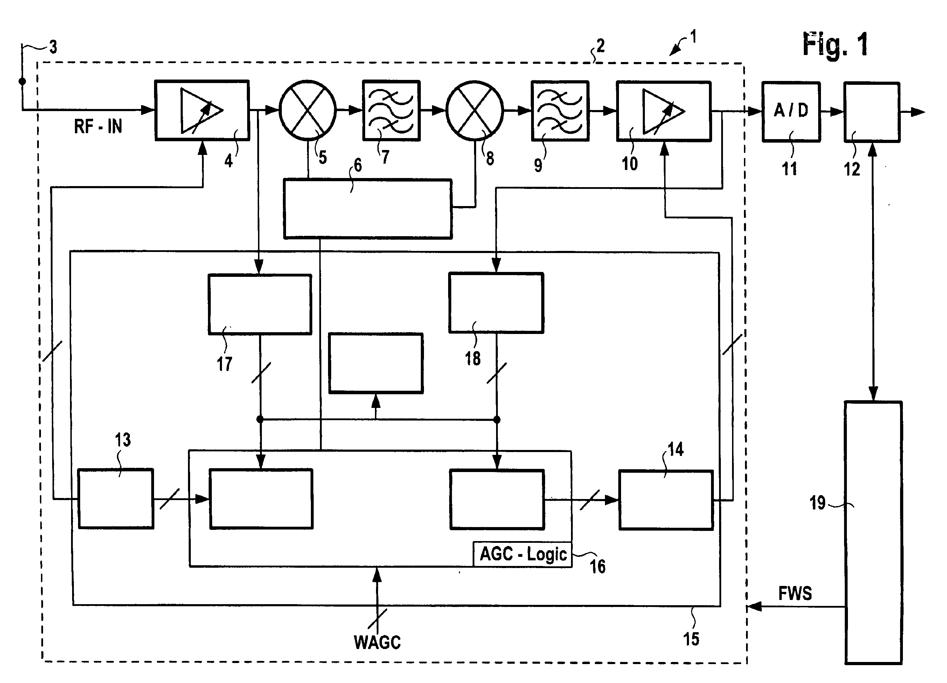

Die einzige Figur zeigt ein Blockdiagramm einer erfindungsgemäßen Empfangsschaltung für dem Empfang von OFDM-Empfangssignalen gemäß einer bevorzugten Ausführungsform der Erfindung. Darin ist eine Empfangsschaltung 1 zum Empfangen eines Empfangssignals gezeigt. Die Empfangsschaltung 1 weist eine Eingangschaltung 2 auf, die das Empfangssignal unmittelbar empfängt. Im dargestellten Beispiel ist das Empfangssignal ein Funksignal RF-IN, das mit einer Funkfrequenz über eine Antenne 3 empfangen wird. Das Funksignal trägt beispielsweise DAB-Daten (digital audio broadcasting) für digitalen Radioempfang.

Die Eingangschaltung 2 hat die Aufgabe, das empfangene Empfangssignal in ein Ausgangssignal einer vorbestimmten Ausgangsfrequenz und einer vorbestimmten Ausgangssignalstärke umzuwandeln. Dazu wird das empfangene Empfangssignal einer ersten Verstärkerstufe 4 zugeführt, die das empfangene Empfangssignal gemäß einem ersten bereitgestellten Teilverstärkungswert verstärkt und einem ersten Mischer 5 zuführt, der das verstärkte Empfangssignal mit einer ersten Mischfrequenz mischt und wandelt. Die erste Mischfrequenz wird von einer Abstimmeinrichtung 6 zur Verfügung gestellt. Das gemischte Empfangssignal vom Ausgang des Mischers 5 wird in einem ersten Filter 7 so gefiltert, dass ein Zwischensignal auf einer Zwischenfrequenz erhalten wird.

Das Zwischensignal vom Ausgang des ersten Filters 7 wird einem zweiten Mischer 8 zur Verfügung gestellt, der das Zwischensignal mit einem zweiten Mischsignal mit einer zweiten Mischfrequenz mischt. Das zweite Mischsignal wird ebenfalls von der Abstimmeinrichtung 6 zur Verfügung gestellt. Das gemischte Zwischensignal wird einem zweiten Filter 9 zur Verfügung gestellt, der das gemischte Zwischensignal erneut filtert, so dass man ein Ausgangssignal bei einer Ausgangsfrequenz erhält.

Das Ausgangssignal wird anschließend in einer zweiten Verstärkungsstufe 10 gemäß einem zweiten bereitgestellten Teilverstärkungswert verstärkt, um das Ausgangssignal als das Ausgangssignal mit der vorbestimmten Stärke und der vorbestimmten Frequenz zu erhalten.

Das Ausgangssignal wird einem AD-Wandler 11 zugeführt, der in Verbindung mit der nachfolgenden Auswerteeinheit 12 aus dem Ausgangssignal ein Nutzsignal im Basisband generiert und die daraus erhaltenen Nutzdaten einer Weiterverarbeitung durch nachfolgende Schaltungen zur Verfügung stellen kann.

Die durch die Abstimmeinrichtung 6 vorgegebenen Mischfrequenzen dienen dazu, durch Mischen und Filtern ein jeweiliges Ausgangssignal für den AD-Wandler 11 zu generieren, das dieser optimal digitalisieren kann. Das Ausgangssignal weist üblicherweise unabhängig von der Funkfrequenz des detektierten Empfangssignals eine bestimmte Trägerfrequenz bzw. einen bestimmten Frequenzbereich auf. Die Abstimmeinrichtung 6 ist so gesteuert, um den ersten Mischer 5 und den zweiten Mischer 8 jeweils diejenigen Mischfrequenzen zuzuführen, um in Verbindung mit den Filtern ein geeignetes Ausgangssignal am Ausgang der Eingangschaltung 2 zu erhalten.

Der erste Teilverstärkungswert und der zweite Teilverstärkungswert werden der ersten Verstärkerstufe 4 bzw. der zweiten Verstärkerstufe 10 über ein erstes Speicherelement 13 bzw. ein zweites Speicherelement 14 zur Verfügung gestellt. In dem ersten und zweiten Speicherelement 13, 14 ist in digitaler Weise der erste bzw. zweite Teilverstärkungswert abgespeichert und steht der jeweiligen Verstärkungsstufe 4, 10 zur Verfügung, um das an dem jeweiligen Eingang anliegende Signal entsprechend dem jeweiligen Teilverstärkungswert zu verstärken.

Die Empfangsschaltung 1 kann abhängig von einem Frequenzwahlsignal FWS, das der Eingangschaltung 2 zur Verfügung gestellt wird, einen Kontextwechsel durchführen. Ein Kontext stellt einen Frequenzbereich dar, auf dem ein Empfangssignal übertragen wird, und in dem Nutzdaten vorhanden sind. Ein Kontextwechsel kann aus verschiedenen Gründen durchgeführt werden. Zum einen kann ein Kontextwechsel durchgeführt werden, wenn von den Inhalten in einem ersten Kontext zu den Inhalten in einem zweiten Kontext gewechselt werden soll. Weiterhin ist es möglich, einen Kontextwechsel kurzfristig durchzuführen, so dass von einem ersten Kontext auf einen zweiten Kontext innerhalb eines Rahmens des Empfangssignals gesprungen wird, um dort lediglich eine Information über die darin vorhandenen Nutzdaten zu erhalten. Ein solcher Sprung wird üblicherweise durchgeführt, während in dem Rahmen des ersten Kontextes keine für das Erhalten der Nutzdaten wesentlichen Nutzsymbole übertragen werden oder ein sonstiges Symbol, beispielsweise ein Synchronisationssymbol, übertragen wird.

Beim Wechsel von einem Kontext auf einen anderen wird beim Empfangen der gleichen Programmquelle ein Empfangssignal in einem anderen Frequenzbereich empfangen. Da die Teilverstärkungswerte für die erste und zweite Verstärkerstufe 4, 10 bezüglich des ersten Kontextes, d.h. bezüglich des Empfangssignals in einem ersten Frequenzbereich eingestellt sind, kann es bei dem Wechsel zu einem weiteren Kontext in einem anderen Frequenzbereich dazu kommen, dass das Ausgangssignal am Ausgang der Eingangschaltung 2 übersteuert ist oder eine zu schwache Signalstärke aufweist, um von dem nachfolgenden AD-Wandler 11 in optimaler Weise digitalisiert werden zu können. Bei einem Kontextwechsel kann dies zu einer Unterbrechung des Nutzdatenstroms führen.

Bei einem kurzfristigen Kontextwechsel, wie er beim sogenannten Snooping auftritt, reicht die Zeit nicht aus, die Teilverstärkungswerte für die Verstärkerstufen 4, 10 der Signalstärke des Empfangssignals im weiteren Frequenzbereich anzupassen. Insbesondere wenn die Signalstärken der Empfangssignale für die verschiedenen Kontexte, d.h. in den verschiedenen Frequenzbereichen, stark unterschiedlich sind, wird versucht, ausgehend von dem eingestellten Teilverstärkungswert beim Empfangen des ersten Kontextes neue Teilverstärkungswerte für den zweiten Kontext einzuregeln, wobei die Zeit, die optimalen Teilverstärkungswerte zu erreichen, beim Snooping jedoch nicht ausreicht.

Diesbezüglich ist vorgesehen, dass das erste und zweite Verstärkungsspeicherelement 13, 14 jeweils zweigeteilt ist, um erste und zweite Teilverstärkungswerte sowohl für den ersten Kontext, als auch für den zweiten Kontext zu speichern. Je nachdem, ob gerade der erste Kontext oder der zweite Kontext empfangen wird, stellen die Verstärkungsspeicherelemente 13, 14 den jeweiligen erste und zweite Teilverstärkungswert bezüglich des ersten oder zweiten Kontextes der jeweiligen Verstärkerstufe 4, 10 zur Verfügung. Wird von einem ersten Kontext zum ersten Mal auf einen zweiten Kontext gesprungen, beginnt die Eingangschaltung, das empfangene OFDM- Empfangssignal des zweiten Kontextes mit einer voreingestellten Verstärkung, d.h. mit vorbestimmten ersten und zweiten Teilverstärkungswerten zu verstärken und beginnt das Anpassen der Teilverstärkungswerte, so dass in der Regel nach mehreren Zyklen ein optimaler Gesamtverstärkungswert erreicht wird. Beim Zurückwechseln zum Empfangen des ersten Kontextes wird dann auf die entsprechenden ersten und zweiten Teilverstärkungswerte bezüglich des ersten Kontextes zugegriffen und diese der ersten und zweiten Verstärkungsstufe 4, 10 zur Verfügung gestellt. Dabei wird davon ausgegangen, dass während des kurzzeitigen Wechsels zu einem zweiten Kontext sich die Signalstärke des Empfangssignals des ersten Kontextes nicht so stark ändert, dass eine ordnungsgemäße Auswertung des ersten Empfangssignals über den AD-Wandler 11 und die Auswerteeinheit 12 nicht mehr möglich ist. Der Wechsel des Kontextes kann durch das Frequenzwahlsignal gesteuert werden.

Das Einstellen der Verstärkung der Eingangschaltung 2 wird in einer Verstärkungssteuerung 15 übernommen. Die Verstärkungssteuerung 15 stellt den ersten und zweiten Teilverstärkungswert abhängig von der Signalstärke des empfangenen Empfangssignals so ein, dass am Ausgang der Eingangschaltung 2 das Zwischensignal mit der optimalen Signalstärke bei einer vorgegebenen Zwischenfrequenz anliegt. Die Verstärkungssteuerung weist eine Steuereinheit 16 auf, die aus der detektierten Signalstärke des empfangenen Empfangssignals den ersten Teilverstärkungswert und aus der Signalstärke des von der Eingangschaltung ausgegebenen Zwischensignals den zweiten Teilverstärkungswert ermittelt.

Zur Bestimmung der Signalstärke des empfangenen Empfangssignals ist ein erster Pegeldetektor 17 vorgesehen, der mit dem Ausgang der ersten Verstärkungsstufe 4 verbunden ist, um die Signalstärke des verstärkten empfangenen Empfangssignals zu erhalten. Die gemessene Signalstärke wird der Steuereinheit 16 zur Verfügung gestellt und dort ein erster Teilverstärkungswert ermittelt, der in dem ersten Verstärkungsspeicherelement 13 gespeichert wird. Vorzugsweise wird das erste Verstärkungsspeicherelement 13 erneut beschrieben, wenn sich eine Änderung des ersten Teilverstärkungswerts ergibt.

Insbesondere kann in der Steuereinheit 16 vorgesehen sein, dass die Signalstärken, die durch den ersten Pegeldetektor 17 detektiert werden, mit vorgegebenen Signalstärkenbereichen verglichen wird, und, je nachdem, in welchen der Signalstärkenbereiche die detektierte Signalstärke des verstärkten Empfangssignals liegt, der erste Teilverstärkungswert angepasst wird. Dazu können Schwellwerte vorgesehen sein, die die Grenzen zwischen den Signalstärkenbereichen definieren. Da der erste Pegeldetektor 17 die Signalstärke des bereits verstärkten Empfangssignals ermittelt, errechnet die Steuereinheit aus der eingestellten Verstärkung der ersten Verstärkungsstufe 4 die Signalstärke des empfangenen Empfangssignals. Um ein ständiges Wechseln der ersten Teilverstärkungswerte zu vermeiden, wenn die Signalstärke des empfangenen Empfangssignals sich nahe oder auf einem ersten Schwellwert befindet, können einer oder mehrere der ersten Schwellwerte mit einer Hysterese versehen sein, so dass ein Wechsel des ersten Teilverstärkungswerts nur dann vorgenommen wird, wenn sich die Signalstärke des empfangenen Empfangssignals mit ausreichendem Abstand zu dem ersten Signalstärkeschwellwert bzw. für eine ausreichende Zeitdauer in dem jeweils benachbarten Signalstärkebereich befindet. Die Schwellwerte und die Hysterese können adaptiv abhängig von der Empfangssituation der gemessenen Bitfehlerrate, der Feldstärke, der Störfeldstärke, der Basisbandenergie usw. eingestellt werden.

Die Steuereinheit 16 stellt auch den zweiten Teilverstärkungswert ein. Dazu ist ein zweiter Pegeldetektor 18 vorgesehen, der den Signalpegel des von der Eingangschaltung 2 ausgegebenen Ausgangssignals detektiert. Dieser Signalpegel wird der Steuereinheit 16 zur Verfügung gestellt, die in Kenntnis des ersten und zweiten eingestellten Teilverstärkungswerts daraus die Signalstärke des empfangenen Empfangssignals berechnen kann und abhängig von der Abweichung der Signalstärke des empfangenen Empfangssignals von einem vorgegebenen Sollwert für das Ausgangssignal, der zu einer optimalen Auswertbarkeit des Ausgangssignals für den AD-Wandler 11 führt, wird der zweite Teilverstärkungswert eingestellt. Vorzugsweise handelt es sich bei der Einstellung des zweiten Teilverstärkungswerts um eine differentielle Regelung, d.h. der zweite Teilverstärkungswert wird entsprechend der Abweichung zwischen der Sollsignalstärke und der empfangenen Signalstärke des Empfangssignals erhöht oder erniedrigt. Insbesondere kann die Größe des Schritts, um den der zweite Teilverstärkungswert erhöht oder erniedrigt wird, adaptiv abhängig von der Differenz zwischen der Sollsignalstärke und der Istsignalstärke des empfangenen Empfangssignals bzw. Ausgangssignals sein und von der Empfangssituation der gemessenen Bitfehlerrate, der Feldstärke, der Störfeldstärke, der Basisbandenergie usw. abhängen. Auf diese Weise wird der erste und der zweite Teilverstärkungswert für den zu empfangenen Kontext zyklisch oder abhängig von einem vorgegebenen Stellsignal zu bestimmten Zeitpunkten angepasst. Es kann weiterhin ein zweiter Schwellwert vorgegeben sein, um den die Differenz zwischen der Sollsignalstärke und der Istsignalstärke des empfangenen Empfangssignals abweichen muss, bevor ein Erhöhen bzw. ein Erniedrigen des zweiten Teilverstärkungswerts durchgeführt wird. In weiteren Ausführungsformen kann die Einstellung des ersten Teilverstärkungswerts auch differentiell, sowie die Einstellung des zweiten Teilverstärkungswerts auch proportional vorgesehen werden.

Die Steuereinheit 16 regelt den ersten und zweiten Teilverstärkungswert in bestimmten Regelzyklen, die adaptiv angepasst werden können, d.h. die Zeitdauer eines Regelzyklus kann abhängig von der Differenz der Sollsignalstärke zur Istsignalstärke des empfangenen Empfangssignals verlängert oder verkürzt werden. Die Pegeldetektoren 17, 18 ermitteln die Signalstärken gemittelt während des Regelzyklus, so dass Signalspitzen herausgemittelt werden.

Die Auswerteeinheit 12 demoduliert das von dem AD-Wandler 11 digitalisierte Ausgangssignal, um ein Nutzsignal zu erhalten, aus dem die Auswerteeinheit 12 wiederum die Nutzdaten gewinnt. Dies erfolgt, indem über das Nutzsignal Zeitfenster gelegt werden, um die einzelnen Symbole des Nutzsignals zu detektieren. Da es sein kann, dass ein Rahmen des Empfangssignals zur Synchronisation der Auswerteeinheit ein sogenanntes Nullsymbol aufweist, d.h. ein Symbol, in dem kein Signal vorhanden ist, ist es notwendig, die Anpassung der Verstärkung während des Nullsymbols zu unterbrechen, da während des Nullsymbols fälschlicherweise die Signalstärke als zu gering detektiert werden würde, da kein Signal übertragen wird. Dies erfolgt mithilfe eines Wartesignals WAGC, das durch die Auswerteeinheit 12 während des Nullsymbols des jeweiligen Kontextes generiert wird.

Der Kontextwechsel kann von einem Steuersystem 19 vorgegeben werden. Die Anweisung zum Kontextwechsel enthält beispielsweise eine Frequenzbereichsinformation, die angibt, zu welcher Trägerfrequenz, d.h. zu welchem Frequenzbereich gewechselt werden soll, um dort ein Empfangssignal zu empfangen. Die Verstärkungssteuerung verwendet diese Frequenzkanalinformation und passt die Abstimmeinrichtung 6 (z.B. PLL, Frequenzteiler usw.) so an, dass dem ersten und zweiten Mischer 5, 8 das jeweils für die jeweilige Frequenzwandlung notwendige Mischsignal mit der jeweiligen Mischfrequenz bereitgestellt wird. Dieses Verfahren ist aus dem Stand der Technik hinlänglich bekannt und auf eine ausführliche Beschreibung wird deshalb verzichtet.

Bei einem Kontextwechsel in Form eines sogenannten Snooping steht das Empfangen der Inhaltsinformation des Kontextes, auf den kurzzeitig gewechselt wird, im Vordergrund. Die Inhaltsinformation enthält Angaben über den Inhalt der Nutzdaten, z.B. beim digitalen Radioempfang, die Sendernamen. Da es vorkommen kann, dass auf zwei Kontexten die gleiche Information übertragen wird, wie es beispielsweise bei zwei örtlich versetzten Radiosendern der Fall sein kann, ist die Information über die Signalstärke des jeweiligen Signals wichtig, um entscheiden zu können, welches der Empfangssignale für den Radioempfang ausgewertet wird. Zusätzlich kann es wichtig sein, welches der Empfangssignale möglichst wenig Störsignale enthält, die insbesondere dann in großem Maße vorhanden sind, wenn die Signalstärken von zu dem Frequenzbereich des Empfangssignals benachbarten Frequenzbereichen im Vergleich zur Signalstärke des zu empfangenen Empfangssignals relativ hoch ist. Um dies zu ermitteln, sieht die Auswerteeinheit 12 vor, die Nutzsignalstärke des Nutzsignals zu messen und die Nutzsignalstärke und mittels dem ersten und dem zweiten Teilverstärkungswert die Feldstärke des Empfangssignals im ersten und zweiten Frequenzbereich, d.h. im ersten bzw. zweiten Kontext, zu bestimmen, so dass abhängig von diesem oder anderen Parametern herausgefunden werden kann, ob das Empfangssignal des ersten Kontextes bzw. des zweiten Kontextes für den Empfang der Nutzdaten verwendet werden soll. Dies wird im Steuersystem 19 durchgeführt, das als Ergebnis das Frequenzwahlsignal FWS ausgibt, um den entsprechenden Kontext auszuwählen.

Bezüglich der Störsignalstärke kann die Auswerteeinheit 12 die Nutzsignalstärke (Basisbandenergie) und die zweite Signalstärke, d.h. die Signalstärke des von der Eingangschaltung 2 ausgegebenen Ausgangssignals, miteinander vergleichen, um die Störsignalstärke von einem zu dem ersten bzw. zweiten Frequenzbereich benachbarten Frequenzbereich zu bestimmen. Dies ist möglich, da das erste Filter 7 und das zweite Filter 9 das empfangene Empfangssignal bzw. den Frequenzbereich so weit gefiltert hat, dass im Wesentlichen nur noch der Frequenzbereich des zu empfangenden Empfangssignals und Teile der benachbarten Frequenzbereiche in einer nennenswerten Signalstärke in dem bereitgestellten Ausgangssignal vorhanden sind. Durch einen Vergleich (Subtraktion) der Nutzsignalstärke mit der Signalstärke des Zwischensignals lässt sich der Anteil von Signalen in benachbarten Frequenzbereichen (Störsignalstärke) bezüglich der Signalstärke des Ausgangssignals ermitteln. Dieser Anteil gibt das Maß für eine Störung des Nutzsignals an. Das Vergleichen kann durchgeführt werden, indem die Nutzsignalstärke auf einen Nutzsignalanteil des Ausgangssignals zurückgerechnet wird und dann der Nutzsignalanteil mit dem Ausgangssignal, das von der Eingangschaltung 2 ausgegeben wird, verglichen wird und daraus die Störsignalstärke bestimmt wird. Ein Wert für die Störsignalstärke wird dann dem Kontext zugewiesen, und die Auswerteeinheit 12 kann abhängig von der zugewiesenen Störsignalstärke und/oder anderen Größen einen Kontextwechsel durchführen oder nicht. Der Kontextwechsel wird durch das Steuersystem 19 initiiert. Dazu stellt die Verstärkungssteuerung 15 dem Steuersystem 19 die gemessenen ersten und zweiten Signalpegel bzw. den ersten und zweiten Teilverstärkungswert zur Verfügung, um die Signalstärke des in einem bestimmten Frequenzbereich vorhandenen Empfangssignals zurückrechnen zu können.

Das Steuersystem 19 gibt einen Kontextwechsel von einem ersten Frequenzbereich zu einem zweiten Frequenzbereich vor. Es können auch Kontextwechsel zwischen mehr als zwei Frequenzbereichen durchgeführt werden, was jedoch notwendig macht, dass die Verstärkungspeicherelemente 13, 14 ausreichend Speicherplatz für jeden der ersten bzw. zweiten Teilverstärkungswerte der Kontexte aufweist. Es ist wesentlich, dass bei einem Kontextwechsel, der jeweils dem Kontext zugehörige Teilverstärkungswert der jeweiligen Verstärkerstufe 4, 10 unmittelbar zugeordnet wird, so dass das dem Kontext zugeordnete Empfangssignal in dem zugeordneten Frequenzbereich optimal durch den AD-Wandler 11 und die Auswerteeinheit 12 ausgewertet werden kann.

## Patentansprüche

1. Empfangsschaltung (1) zum Empfangen von OFDM-Empfangssignalen, mit einer Eingangsschaltung (2), um abhängig von einem Frequenzwahlsignal ein erstes Empfangssignal in einem ersten Frequenzbereich oder ein zweites Empfangssignal in einem zweiten Frequenzbereich umzusetzen, um ein Ausgangssignal mit Nutzdaten zu erhalten, mit einer digital einstellbaren Verstärkereinheit (4, 10), um das Ausgangssignal mit einer vorbestimmten Signalstärke zur Verfügung zu stellen,mit einer Verstärkersteuereinheit (15), die so mit der Verstärkereinheit verbunden ist, um bei einem Kontextwechsel zwischen dem ersten Empfangssignal und dem zweiten Empfangssignal zu wechseln, ohne dass der Nutzdatenstrom bezüglich des ersten Empfangssignals wahrnehmbar unterbrochen wird, und um beim Empfangen des ersten Empfangssignals die Verstärkung der Verstärkereinheit (4, 10) gemäß einem ersten bereitgestellten Verstärkungswert und beim Empfangen des zweiten Empfangssignals die Verstärkung der Verstärkereinheit (4, 10) gemäß einem zweiten bereitgestellten Verstärkungswert einzustellen und wobei die Verstärkereinheit ein erstes Verstärkerelement (4) zum Verstärken des Empfangssignals mit einem ersten Teilverstärkungswert und ein zweites Verstärkerelement (10) zum Verstärken eines Ausgangssignals mit einem zweiten Teilverstärkungswert aufweist, wobei ein erster Frequenzumsetzer (5) zum Umsetzen des verstärkten Empfangssignals in ein Zwischensignal und ein zweiter Frequenzumsetzer (8) zum Umsetzen des Zwischensignals in das Ausgangssignal vorgesehen ist, um das Ausgangssignal mit der vorbestimmten Signalstärke zu erhalten und wobei eine erste Verstärkungsspeichereinheit (13) zum Speichern des ersten Teilverstärkungswerts und eine zweite Verstärkungsspeichereinheit (14) zum Speichern eines zweiten Teilverstärkungswerts vorgesehen ist, **dadurch gekennzeichnet, dass** bei Empfang eines Rahmens, der ein Nullsymbol aufweist, die Anpassung der Verstärkung während des Nullsymbols unterbrochen wird, indem eine Auswerteeinheit (12) während des Nullsymbols des jeweiligen Kontextes ein Wartesignal (WAGC) generiert.

2. Empfangsschaltung (1) nach Anspruch 1, wobei die Verstärkereinheit die Verstärkung zu durch ein Aktivierungssignal vorgegebenen Zeitpunkten einstellt.

3. Empfangsschaltung (1) nach einem der Ansprüche 1 oder 2, wobei die Verstärkersteuereinheit den ersten und den zweiten Teilverstärkungswert adaptiv anpasst.

4. Empfangsschaltung (1) nach Anspruch 3, wobei die Verstärkersteuereinheit den ersten Teilverstärkungswert abhängig von der Differenz zwischen der aktuellen Signalstärke und einem vorbestimmten Signalstärkebereich des Empfangssignals einstellt und/oder den zweiten Verstärkungswert abhängig von der Differenz zwischen der aktuellen Signalstärke des Ausgangssignals und einer vorbestimmten Signalstärke des Ausgangssignals ändert.

5. Empfangsschaltung (1) nach Anspruch 4, wobei die Verstärkersteuereinheit (15) einen ersten Pegeldetektor (17) aufweist, um eine erste Signalstärke des Empfangssignals zu detektieren, und einen zweiten Pegeldetektor (18) aufweist, um eine zweite Signalstärke des Ausgangssignals zu detektieren.

6. Empfangsschaltung (1) nach Anspruch 5, wobei die Verstärkersteuereinheit (15) mehrere erste Signalstärken-Bereiche mit Hilfe von einem oder mehreren ersten Schwellwerten, die die Grenzen der Signalstärken-Bereiche bilden, definiert, um den ersten Teilverstärkungswert abhängig davon festzulegen, in welchem der ersten Signalstärken-Bereiche sich die erste Signalstärke des Zwischensignals befindet.

7. Empfangsschaltung (1) nach Anspruch 6, wobei mindestens einer der ersten Schwellwerte der mehreren ersten Signalstärken-Bereiche eine Hysterese aufweist.

8. Empfangsschaltung (1) nach Anspruch 6 oder 7, wobei die ersten Schwellwerte und die Hysterese adaptiv durch die Verstärkersteuereinheit (15) einstellbar sind.

9. Empfangsschaltung (1) nach Anspruch 5 bis 8, wobei die Verstärkersteuereinheit (15) die Differenz zwischen der zweiten Signalstärke und der vorbestimmten Signalstärke des Ausgangssignals ermittelt und abhängig von der Differenz eine Änderung des zweiten Teilverstärkungswertes vornimmt.

10. Empfangsschaltung (1) nach Anspruch 9, wobei die Verstärkersteuereinheit (15) so gestaltet ist, um die Änderung des Betrags des zweiten Teilverstärkungswertes umso größer einzustellen, je größer der Betrag der Differenz zwischen der aktuellen zweiten Signalstärke des Ausgangssignals und der vorbestimmten Signalstärke des Ausgangssignals ist.

11. Empfangsschaltung (1) nach einem der Ansprüche 5 bis 10, wobei eine Auswerteeinheit vorgesehen ist, um das Ausgangssignal zu empfangen und daraus ein Nutzsignal im Basisband zu generieren, wobei die Auswerteeinheit eine Nutzsignalstärke des Nutzsignals misst, wobei der Auswerteeinheit die erste und/oder die zweite Signalstärke sowie der erste und der zweite Teilverstärkungswert zur Verfügung gestellt wird, wobei aus der Nutzsignalstärke und dem ersten und/oder zweiten Teilverstärkungswert die Feldstärke des Empfangssignals im ersten und zweiten Frequenzbereich bestimmbar ist, um für den Empfang der Nutzdaten den ersten oder den zweiten Frequenzbereich abhängig von der Feldstärke des Empfangssignals auszuwählen.

12. Empfangsschaltung (1) nach Anspruch 9, wobei die Auswerteeinheit die Nutzsignalstärke und die zweite Signalstärke miteinander vergleicht, um die Störsignalstärke von einem zu dem ersten bzw. zweiten Frequenzbereich benachbarten Frequenzbereich zu bestimmen, wobei die Auswerteeinheit weiterhin den ersten Frequenzbereich oder den zweiten Frequenzbereich abhängig für den Empfang des Empfangssignals von der Störsignalstärke auswählt.

13. Empfangsschaltung (1) nach Anspruch 12, wobei die Auswerteeinheit abhängig von der Störsignalstärke einen Kontextwechsel durchführt.

14. Verfahren zum Empfangen von OFDM- Empfangssignalen, wobei abhängig von einem Frequenzwahlsignal ein erstes Empfangssignal in einem ersten Frequenzbereich oder ein zweites Empfangssignal in einem zweiten Frequenzbereich demoduliert wird, um ein Ausgangssignal mit Nutzdaten zu erhalten, wobei das Empfangssignal gemäß einer Verstärkung so verstärkt wird, um ein Ausgangssignal mit einer vorbestimmten Signalstärke zu erhalten, wobei bei einem Kontextwechsel zwischen dem Empfangen des ersten Empfangssignal und dem Empfangen des zweiten Empfangssignals gewechselt wird, ohne das Ausgangssignal bezüglich des ersten Empfangssignals zu unterbrechen, und wobei beim Empfangen des ersten Empfangssignals das erste Empfangssignal gemäß einem ersten Verstärkungswert und beim Empfangen des zweiten Empfangssignals das zweite Empfangssignal gemäß einem zweiten Verstärkungswert verstärkt wird, wobei das erste und/oder zweite Empfangssignal mit einem ersten Teilverstärkungswert und ein aus dem Empfangssignal erhaltenes Zwischensignal mit einem zweiten Teilverstärkungswert verstärkt wird, wobei das verstärkte Empfangssignal durch ein Mischen in das Zwischensignal gewandelt und das Zwischensignal durch ein weiteres Mischen in das Ausgangssignal gewandelt wird, um das Ausgangssignal mit der vorbestimmten Signalstärke zu erhalten **dadurch** gekennzeicihnet, dass bei Empfang eines Rahmens, der ein Nullsymbol aufweist, die Anpassung der Verstärkung während des Nullsymbols unterbrochen wird, indem die Auswerteeinheit (12) während des Nullsymbols des jeweiligen Kontextes ein Wartesignal (WAGC) generiert.

15. Verfahren nach Anspruch 14, wobei der erste Teilverstärkungswert abhängig von der Differenz zwischen der aktuellen Signalstärke und einen vorbestimmten Signalstärkebereich des Empfangssignals eingestellt wird und/oder der zweite Verstärkungswert abhängig von der Differenz zwischen der aktuellen Signalstärke des Ausgangssignals und einer vorbestimmten Signalstärke des Ausgangssignals geändert wird.

16. Verfahren nach Anspruch 15, wobei eine erste Signalstärke des Empfangssignals und eine zweite Signalstärke des Ausgangssignals detektiert wird.

17. Verfahren nach einem der Ansprüche 16, wobei für das erste und zweite Empfangssignal aus den jeweiligen Ausgangssignalen ein Nutzsignal im Basisband generiert wird, wobei eine Nutzsignalstärke des jeweilige Nutzsignals gemessen wird, wobei aus den Nutzsignalstärken und den jeweiligen ersten und/oder zweiten Teilverstärkungswert die Signalstärken des ersten und zweiten Empfangssignals im ersten Frequenzbereich und im zweiten Frequenzbereich bestimmt wird, um für den Empfang der Nutzdaten den ersten oder den zweiten Frequenzbereich abhängig von der ersten Signalstärke des ersten bzw. zweiten Empfangssignals auszuwählen.

18. Verfahren nach Anspruch 17, wobei die Nutzsignalstärken des ersten und des zweiten Empfangssignals und die jeweilige zweite Signalstärke miteinander verglichen wird, um die Störsignalstärken von einem zu dem jeweiligen Frequenzbereich des ersten bzw. zweiten Empfangssignals benachbarten Frequenzbereich zu bestimmen, wobei weiterhin der erste Frequenzbereich oder der zweite Frequenzbereich abhängig von der Störsignalstärke ausgewählt wird.

## Claims

1. Reception circuit (1) for receiving OFDM received signals, having an input circuit (2) for the purpose of taking a frequency selection signal as a basis for converting a first received signal in a first frequency range or a second received signal in a second frequency range in order to obtain an output signal with useful data, having a digitally adjustable amplifier unit (4, 10) for the purpose of providing the output signal at a predetermined signal level, having an amplifier control unit (15) which is connected to the amplifier unit for the purpose of changing between the first received signal and the second received signal in the event of a change of context without perceptibly interrupting the useful data stream for the first received signal, and for the purpose of adjusting the gain of the amplifier unit (4, 10) in line with a first provided gain value when the first received signal is received and of adjusting the gain of the amplifier unit (4, 10) in line with a second provided gain value when the second received signal is received, and where the amplifier unit has a first amplifier element (4) for amplifying the received signal using a first elemental gain value and a second amplifier element (10) for amplifying an output signal using a second elemental gain value, where a first frequency converter (5) is provided for converting the amplified received signal to an intermediate signal and a second frequency converter (8) is provided for converting the intermediate signal to the output signal in order to obtain the output signal at the predetermined signal level, and where a first gain memory unit (13) is provided for storing the first elemental gain value and a second gain memory unit (14) is provided for storing a second elemental gain value, **characterized in that** reception of a frame which has a null symbol involves the matching of the gain being interrupted during the null symbol by virtue of an evaluation unit (12) generating a wait signal (WAGC) during the respective context's null symbol.

2. Reception circuit (1) according to Claim 1, where the amplifier unit adjusts the gain at times prescribed by an activation signal.

3. Reception circuit (1) according to one of Claims 1 and 2, where the amplifier control unit matches the first and the second elemental gain value adaptively.

4. Reception circuit (1) according to Claim 3, where the amplifier control unit adjusts the first elemental gain value on the basis of the difference between the present signal level and a predetermined signal level range for the received signal and/or changes the second gain value on the basis of the difference between the present signal level of the output signal and a predetermined signal level for the output signal.

5. Reception circuit (1) according to Claim 4, where the amplifier control unit (15) has a first level detector (17) for the purpose of detecting a first signal level for the received signal and has a second level detector (18) for the purpose of detecting a second signal level for the output signal.

6. Reception circuit (1) according to Claim 5, where the amplifier control unit (15) defines a plurality of first signal level ranges using one or more first threshold values which form the boundaries of the signal level ranges in order to stipulate the first elemental gain value on the basis of which one of the first signal gain ranges contains the first signal level of the intermediate signal.

7. Reception circuit (1) according to Claim 6, where at least one of the first threshold values of the plurality of first signal level ranges exhibits hysteresis.

8. Reception circuit (1) according to Claim 6 or 7, where the first threshold values and the hysteresis can be adjusted adaptively by the amplifier control unit (15).

9. Reception circuit (1) according to Claims 5 to 8, where the amplifier control unit (15) ascertains the difference between the second signal level and the predetermined signal level of the output signal and takes the difference as a basis for changing the second elemental gain value.

10. Reception circuit (1) according to Claim 9, where the amplifier control unit (15) is designed to adjust the change to the absolute value of the second elemental gain value to be larger the larger the absolute value of the difference between the present second signal level of the output signal and the predetermined signal level of the output signal.

11. Reception circuit (1) according to one of Claims 5 to 10, where an evaluation unit is provided in order to receive the output signal and to generate a useful signal in baseband therefrom, where the evaluation unit measures a useful signal level for the useful signal, where the evaluation unit provides the first and/or the second signal level and also the first and the second elemental gain value, and where the useful signal level and the first and/or second elemental gain value can be used to determine the field strength of the received signal in the first and second frequency ranges in order to select the first or the second frequency range for receiving the useful data on the basis of the field strength of the received signal.

12. Reception circuit (1) according to Claim 9, where the evaluation unit compares the useful signal level and the second signal level with one another in order to determine the interference signal level of a frequency range adjacent to the first and second frequency ranges, with the evaluation unit also selecting the first frequency range or the second frequency range for receiving the received signal on the basis of the interference signal level.

13. Reception circuit (1) according to Claim 12, where the evaluation unit performs a change of context on the basis of the interference signal level.

14. Method for receiving OFDM received signals, where a frequency selection signal is taken as a basis for demodulating a first received signal in a first frequency range or a second received signal in a second frequency range in order to obtain an output signal with useful data, where the received signal is amplified in line with a gain in order to obtain an output signal at a predetermined signal level, where a change of context involves changing between reception of the first received signal and reception of the second received signal without interrupting the output signal for the first received signal, and where reception of the first received signal involves the first received signal being amplified in line with a first gain value and reception of the second received signal involves the second received signal being amplified in line with a second gain value, where the first and/or second received signal is amplified using a first elemental gain value and an intermediate signal obtained from the received signal is amplified using a second elemental gain value, where the amplified received signal is converted by mixing into the intermediate signal and the intermediate signal is converted by further mixing into the output signal in order to obtain the output signal at the predetermined signal level, **characterized in that** reception of a frame which has a null symbol involves the matching of the gain being interrupted during the null symbol by virtue of the evaluation unit (12) generating a wait signal (WAGC) during the respective context's null symbol.

15. Method according to Claim 14, where the first elemental gain value is adjusted on the basis of the difference between the present signal level and a predetermined signal level range for the received signal and/or the second gain value is changed on the basis of the difference between the present signal level of the output signal and a predetermined signal level for the output signal.

16. Method according to Claim 15, where a first signal level for the received signal and a second signal level for the output signal are detected.

17. Method according to Claim 16, where a useful signal is generated in baseband for the first and second received signals from the respective output signals, where a useful signal level for the respective useful signal is measured, and where the useful signal levels and the respective first and/or second elemental gain values are used to determine the signal levels of the first and second received signals in the first frequency range and in the second frequency range in order to select the first or the second frequency range for receiving the useful data on the basis of the first signal level of the first and second received signals.

18. Method according to Claim 17, where the useful signal levels of the first and second received signals and the respective second signal level are compared with one another in order to determine the interference signal levels of a frequency range adjacent to the respective frequency range of the first and second received signals, the first frequency range or the second frequency range also being selected on the basis of the interference signal level.

## Revendications

1. Récepteur (1) pour recevoir des signaux de réception en modulation OFDM comprenant un circuit d'entrée (2) pour convertir un premier signal de réception dans une première plage de fréquence ou un second signal de réception dans une seconde plage de fréquence en fonction d'un signal de sélection de fréquence, pour obtenir un signal de sortie avec des données utiles,
un amplificateur numérique réglable (4, 10) pour fournir le signal de sortie avec une amplitude de signal prédéfinie,
une unité de commande d'amplificateur (15) reliée à l'amplificateur pour alterner qu'en cas de changement de contexte, entre le premier signal de réception et le second signal de réception sans que le flux des données utiles pour le premier signal de réception ne soit interrompu de manière perceptible et pour qu'en cas de réception du premier signal de réception, régler l'amplification de l'amplificateur (4, 10) selon un premier coefficient d'amplification fourni et à la réception du second signal d'amplification, régler l'amplification de l'amplificateur (4, 10) selon un second coefficient d'amplification fourni et
l'amplificateur comporte un premier élément d'amplification (4) pour amplifier le signal reçu suivant un premier coefficient partiel d'amplification et un second élément amplificateur (10) pour amplifier un signal de sortie suivant un second coefficient partiel d'amplification,
un premier convertisseur de fréquence (5) pour convertir le signal de réception amplifié en un signal intermédiaire et un second convertisseur de fréquence (8) pour convertir le signal intermédiaire en signal de sortie, pour obtenir le signal de sortie avec une amplitude de signal prédéfinie et une première unité de mémoire d'amplificateur (13) mémorise la première valeur du coefficient d'amplification partiel et une seconde mémoire d'amplification (14) pour mémoriser une seconde valeur de coefficient d'amplification partiel,
**caractérisé en ce qu'**
à la réception d'une trame avec un symbole zéro, l'adaptation de l'amplification est interrompue pendant le symbole zéro, une unité d'exploitation (12) génèrant un signal d'attente (WAGC) pendant le symbole zéro du contexte respectif.

2. Récepteur (1) selon la revendication 1, dans lequel l'amplificateur règle l'amplification par un signal d'activation à des instants prédéfinis.

3. Récepteur (1) selon l'une des revendications 1 ou 2, selon lequel l'unité de commande d'amplificateur ajuste par adaptation, la première et la seconde valeur partielle d'amplification.

4. Récepteur (1) selon la revendication 3, selon lequel l'unité de commande d'amplification règle la première valeur partielle d'amplification en fonction de la différence entre l'amplification actuelle du signal et une plage prédéfinie d'intensité du signal de réception et/ou la seconde valeur d'amplification en fonction de la différence entre l'intensité actuelle du signal de sortie et une intensité prédéfinie du signal de sortie.

5. Récepteur (1) selon la revendication 4, selon lequel l'unité de commande d'amplification (15) comporte un premier détecteur de niveau (17) pour détecter une première intensité du signal de réception et un second détecteur de niveau (18) pour détecter une seconde intensité du signal de sortie.

6. Récepteur (1) selon la revendication 5, selon lequel l'unité de commande d'amplification (15) définit plusieurs premières plages d'intensité de signal à l'aide desquelles un ou plusieurs premiers seuils forment les limites des plages d'amplification de signal pour fixer, en conséquence, le premier coefficient partiel d'amplification dans lequel la première plage d'amplification de signal contient les premières intensités du signal intermédiaire.

7. Récepteur (1) selon la revendication 6, selon lequel au moins l'un des premiers seuils de plusieurs premières plages d'intensité de signal ont une hystérésis.

8. Circuit de réception (1) selon les revendications 6 ou 7 selon lequel les premiers seuils et l'hystérésis se règlent de manière adaptative par l'unité de commande d'amplification (15).

9. Circuit de réception (1) selon les revendications 5 à 8 selon lequel l'unité de commande d'amplification (15) détermine la différence entre la seconde intensité de signal et l'intensité prédéfinie du signal de sortie et en fonction de la différence, on modifie la seconde valeur du second coefficient partiel d'amplification.

10. Circuit de réception (1) selon la revendication 9 selon lequel l'unité de commande d'amplification (15) est conçue pour régler la variation de l'amplitude de la seconde valeur du coefficient partiel d'amplification, d'autant plus grande que l'amplitude de la différence entre la seconde intensité actuelle du signal de sortie et l'intensité prédéfinie du signal de sortie est grande.

11. Circuit de réception (1) selon l'une des revendications 5 à 10, comportant une unité d'exploitation pour recevoir le signal de sortie et générer à partir de celui-ci un signal utile dans la bande de base, l'unit d'exploitation mesurant l'intensité du signal utile et l'unité d'exploitation fournit la première et/ou la seconde intensité de signal ainsi que la première et la seconde valeur de coefficient partiel d'amplification,
et à partir de l'intensité du signal utile et de la première et/ ou de la seconde valeur du coefficient partiel d'amplification, on détermine l'intensité du champ du signal reçu dans la première et la seconde plage de fréquence pour sélectionner la première ou la seconde plage des fréquences en fonction de l'intensité du champ du signal reçu pour la réception des données utiles.

12. Circuit de réception (1) selon la revendication 9, selon laquelle l'unité d'exploitation compare l'intensité du signal utile et l'intensité du second signal pour déterminer l'intensité des signaux parasites dans une plage de fréquence voisine de la première ou de la seconde plage de fréquence, l'unité d'exploitation choisissant en outre la première plage de fréquence ou la seconde plage de fréquence en fonction de l'intensité des signaux parasites, pour la réception du signal de réception.

13. Récepteur (1) selon la revendication 12 selon lequel l'unité d'exploitation effectue un changement de contexte en fonction de l'intensité du signal parasite.

14. Procédé de réception de signaux de réception en modulation OFDM selon lequel en fonction d'un signal de sélection de fréquence, on démodule un premier signal de réception dans une première plage de fréquence ou un second signal de réception dans une seconde plage de fréquence pour obtenir un signal de sortie contenant des données utiles,
le signal de réception étant amplifié avec un coefficient d'amplification assurant un signal de sortie donnant une intensité de signal prédéfinie, et en cas de changement de contexte, on alterne entre la réception du premier signal de réception et celle du second signal de réception sans couper le signal de sortie pour le premier signal de réception et
à la réception du premier signal de réception, on amplifie le premier signal de réception selon un premier coefficient d'amplification et à la réception du second signal de réception, ce second signal de réception est amplifié selon un second coefficient d'amplification,
le premier et/ou le second signal de réception étant amplifiés par une première valeur d'un coefficient d'amplification partielle et le signal intermédiaire, déduit du signal de réception, est amplifié par une seconde valeur de coefficient d'amplification partielle, le signal de réception amplifié étant converti par un mélange pour donner le signal intermédiaire et le signal intermédiaire est converti par un autre mélange, pour obtenir le signal de sortie, pour que le signal de sortie soit d'une intensité prédéfinie,
**caractérisé en ce qu'**
à la réception d'une trame ayant un symbole zéro, on interrompt l'adaptation de l'amplification pendant le symbole zéro, l'unité d'exploitation (12) génèrant un signal d'attente (WAGC) pendant le symbole zéro du contexte respectif.

15. Procédé selon la revendication 14, selon lequel on règle la première valeur partielle d'amplification en fonction de la différence entre l'intensité actuelle du signal et une plage prédéfinie d'intensité de signal pour le signal de réception et/ou on modifie le second coefficient d'amplification en fonction de la différence entre l'intensité actuelle du signal de sortie et une intensité prédéfinie du signal de sortie.

16. Procédé selon la revendication 15, selon lequel on détecte une première intensité du signal de réception et une seconde intensité du signal de sortie.

17. Procédé selon la revendication 16, selon lequel pour le premier et le second signal de réception, à partir des signaux de sortie respectifs, on génère un signal utile dans la bande de base,
on mesure l'intensité du signal utile respectif, à partir de l'intensité des signaux utiles et des première et/ou seconde valeurs respectives du coefficient d'amplification partielle, on définit l'intensité du premier et du second signal de réception dans la première plage de fréquence et dans la seconde plage de fréquence pour sélectionner pour la réception des données utiles, la première ou la seconde plage de fréquence, en fonction de la première intensité du premier et du second signal de réception.

18. Procédé selon la revendication 17, selon lequel on compare l'intensité des signaux utiles du premier et du second signal de réception et la seconde intensité respective du signal pour déterminer l'intensité du signal parasite d'une plage de fréquence voisine de la plage de fréquence respective du premier ou du second signal de réception, et en outre on sélectionne la première plage de fréquence ou la seconde plage de fréquence en fonction de l'intensité du signal parasite.
